# EUROPEAN PATENT APPLICATION

(11) **EP 4 597 557 A1**
(43) Date of publication of application: **06.08.2025**
(21) Application number: 23870421.7
(22) Date of filing: 18.09.2023
(51) Int. Cl.: H01L 21/673, H01L 21/67, H01L 21/677

(54) **WAFER BOAT AND SEMICONDUCTOR PROCESS APPARATUS**

(30) Priority: 30.09.2022 CN 202211207468
(71) Applicant: Beijing NAURA Microelectronics Equipment Co., Ltd., Beijing 100176 (CN)
(72) Inventor: HUANG, Rongbiao, Beijing 100176 (CN); YANG, Huiping, Beijing 100176 (CN); YANG, Shuai, Beijing 100176 (CN); LI, Cen, Beijing 100176 (CN); GUAN, Xiaochen, Beijing 100176 (CN)
(74) Representative: Cohausz & Florack
(86) International application number: PCT/CN2023/119296
(87) International publication number: WO 2024/067187

(57) **Abstract**

The present disclosure provides a wafer boat and a semiconductor process apparatus. The wafer boat includes a support and a wafer carrier, the wafer carrier includes an edge bearing portion and an extending bearing portion, the edge bearing portion encloses an avoidance space having an opening, the extending bearing portion is connected to the edge bearing portion and extends towards the avoidance space, the edge bearing portion and the extending bearing portion are configured to support a wafer together, the edge bearing portion is configured to support an edge region of the wafer, and the wafer carrier is connected to the support. The above solution can solve a problem in the related art that the wafer has a serious warpage problem when being borne on the wafer boat for processing.

## Description

### TECHNICAL FIELD

The present disclosure relates to the technical field of semiconductor process apparatuses, and in particular, to a wafer boat and a semiconductor process apparatus.

### BACKGROUND

A wafer boat is a device which is in direct contact with a wafer during processing of the wafer by a semiconductor process apparatus, is a key part of the semiconductor process apparatus, and directly affects process quality of the wafer.

In the related art, the wafer boat adopted in the semiconductor process apparatus is a three-column short-tooth boat, toothed grooves are formed at upright columns of the three-column short-tooth boat, and an edge of the wafer is supported on the toothed grooves of the upright columns when the wafer boat bears the wafer. Since the toothed grooves support the edge of the wafer when the wafer boat supports the wafer, the wafer has a serious warpage problem when being borne on the wafer boat for processing.

### SUMMARY

The present disclosure provides a wafer boat and a semiconductor process apparatus, so as to the problem in the related art that the wafer has the serious warpage problem when being borne on the wafer boat for processing.

In order to solve the above technical problem, the present disclosure is implemented as follows.

In a first aspect, the present disclosure provides a wafer boat, including a support and a wafer carrier connected to the support, wherein: the wafer carrier includes an edge bearing portion and an extending bearing portion, the edge bearing portion encloses an avoidance space having an opening, the extending bearing portion is connected to the edge bearing portion and extends towards the avoidance space, the edge bearing portion and the extending bearing portion are configured to support a wafer together, and the edge bearing portion is configured to support an edge region of the wafer.

In a second aspect, the present disclosure further provides a semiconductor process apparatus, including a wafer transfer device and the wafer boat described in the first aspect, and the wafer transfer device is configured to pick the wafer from the wafer boat and place the wafer on the wafer boat.

The technical solutions adopted by the present disclosure can produce the following technical effects.

According to embodiments of the present disclosure, the wafer boat is configured to include the support and the wafer carrier, the wafer carrier is configured as a structure including the edge bearing portion and the extending bearing portion, the edge bearing portion encloses the avoidance space having the opening for allowing the wafer transfer device such as a manipulator to perform pick-place operations, the extending bearing portion is connected to the edge bearing portion and extends towards the avoidance space. With the above configurations, when the wafer boat supports the wafer, the edge bearing portion can support the edge region of the wafer, and the extending bearing portion can support a partial region of the wafer extending from an edge of the wafer to a middle of the wafer, so that the edge region of the wafer and the partial region of the wafer extending from the edge of the wafer to the middle of the wafer can be supported, which can solve the problem in the related art that the wafer while being borne by the wafer boat has the serious warpage problem because just several points of the edge of the wafer are supported.

### BRIEF DESCRIPTION OF DRAWINGS

FIG. 1 is a first schematic structural diagram of a wafer carrier according to an embodiment of the present disclosure;
FIG. 2 is a schematic diagram of a wafer boat viewed from a first visual angle according to an embodiment of the present disclosure;
FIG. 3 is a schematic diagram of a wafer boat viewed from a second visual angle according to an embodiment of the present disclosure;
FIG. 4 is a schematic diagram of a support in a case where a distance between slots is a first distance according to an embodiment of the present disclosure;
FIG. 5 is a schematic diagram of a support in a case where the distance between the slots is a second distance according to an embodiment of the present disclosure;
FIG. 6 is a partial view of a support;
FIG. 7 is a schematic diagram illustrating a wafer carrier carrying a wafer;
FIG. 8 is a schematic diagram of a wafer carrier group;
FIG. 9 is a second schematic diagram of a wafer carrier;
FIG. 10 is a partial view of a wafer carrier connected to a support.

### Description of reference numerals:

100-support, 110-top plate, 120-bottom plate, 130-auxiliary support column, 131-slot, 131a-positioning recess, 140-heat insulation plate,
200-wafer carrier, 210- edge bearing portion, 211-avoidance space, 212-positioning protrusion, 220-extending bearing portion, 221-wafer-transfer-device entrance space,
300-wafer carrier group,
400-wafer transfer device.

### DETAIL DESCRIPTION OF EMBODIMENTS

In order to make the objectives, technical solutions and advantages of the present disclosure clearer, the technical solutions of the present disclosure are clearly and thoroughly described below in conjunction with the specific embodiments of the present disclosure and the corresponding drawings. Apparently, the embodiments described herein are merely some embodiments of the present disclosure, and do not cover all embodiments. All other embodiments derived by those of ordinary skill in the art from the embodiments described herein without inventive work fall within the scope of the present disclosure.

The technical solutions provided in each embodiment of the present disclosure are described in detail below with reference to the drawings.

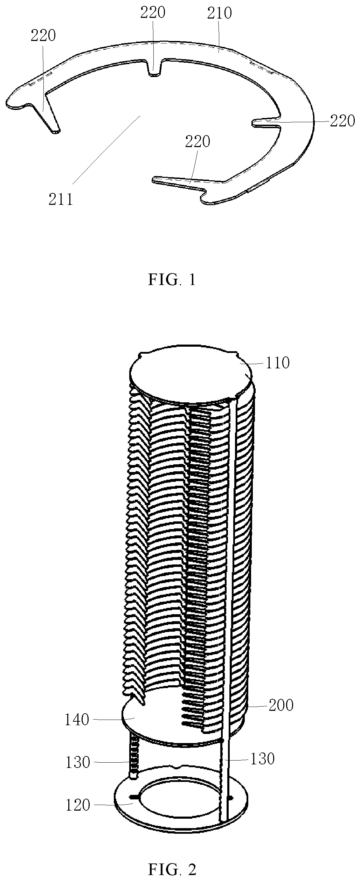

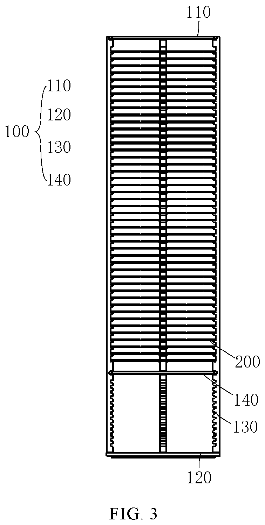

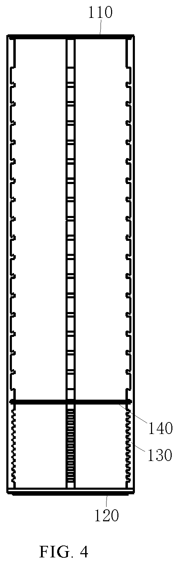

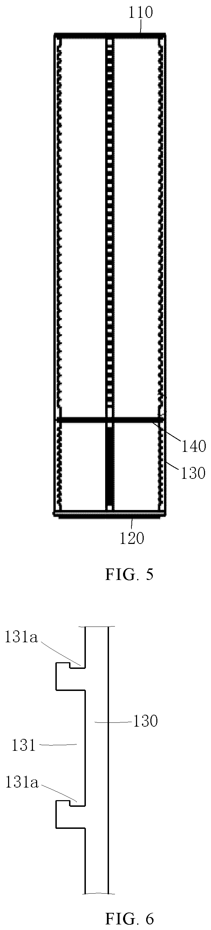

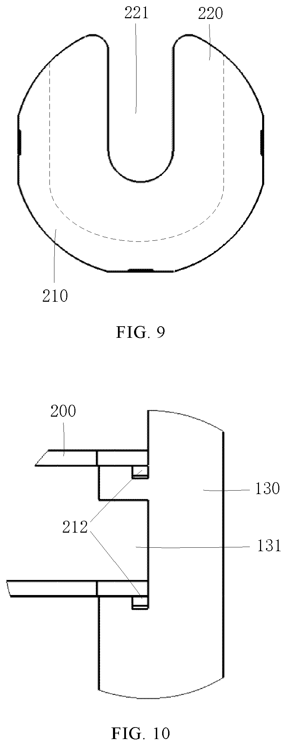

Referring to FIG. 1 to FIG. 10, an embodiment of the present disclosure provides a wafer boat, which may be configured to bear a wafer. During processing of the wafer by a semiconductor process apparatus, the wafer boat is a device which is in direct contact with the wafer. The wafer boat includes a support 100 and a wafer carrier 200 connected thereto. The support 100 is a basis for installation of other parts of the wafer boat. The wafer carrier 200 is configured to bear the wafer. The wafer carrier 200 may be detachably connected to the support 100, so as to facilitate detachment and installation of the wafer carrier 200.

The wafer carrier 200 includes an edge bearing portion 210 and an extending bearing portion 220, the edge bearing portion 210 encloses an avoidance space 211 having an opening, and the extending bearing portion 220 is connected to the edge bearing portion 210 and extends towards the avoidance space 211. The edge bearing portion 210 and the extending bearing portion 220 are configured to support the wafer together, and a bearing surface of the edge bearing portion 210 for bearing the wafer and a bearing surface of the extending bearing portion 220 for bearing the wafer may be coplanar for supporting the wafer together.

The edge bearing portion 210 is configured to support an edge region of the wafer, and the extending bearing portion 220 may be configured to support a partial region of the wafer extending from an edge of the wafer to a middle of the wafer. For example, the extending bearing portion 220 may support the partial region between a circumference of the wafer at one-half of a radius of the wafer and the edge of the wafer.

The avoidance space 211 may include a middle region and an edge region surrounding the middle region, and the middle region may be communicated with the opening of the avoidance space, so as to allow a wafer transfer device 400 to extend into the middle region through the opening to lift the wafer carrier 200 and the wafer or place the wafer carrier 200 and the wafer on the support 100. The extending bearing portion 220 may extend into the edge region of the avoidance space 211. The edge region of the avoidance space 211 is, for example, the region between the circumference of the wafer at one-half of the radius of the wafer and the edge of the wafer.

According to the embodiment of the present disclosure, the wafer boat is configured to include the support 100 and the wafer carrier 200, the wafer carrier 200 is configured as a structure including the edge bearing portion 210 and the extending bearing portion 220, the edge bearing portion 210 encloses the avoidance space 211 having the opening for allowing the wafer transfer device such as a manipulator to perform pick-place operations, the extending bearing portion 220 is connected to the edge bearing portion 210 and extends towards the avoidance space 211. With the above configurations, when the wafer boat supports the wafer, the edge bearing portion 210 can support the edge region of the wafer, and the extending bearing portion 220 can support the partial region of the wafer extending from the edge of the wafer to the middle of the wafer, so that the edge of the wafer and the partial region of the wafer extending from the edge of the wafer to the middle of the wafer can be supported, which can solve the problem in the related art that the wafer while being borne by the wafer boat has the serious warpage problem because just several points of the edge of the wafer are supported.

**In** order to further relieve warpage of the wafer when the wafer carrier 200 bears the wafer, optionally, a plurality of extending bearing portions 220 may be provided and arranged at intervals along an extension direction of the edge bearing portion 210, and each extending bearing portion 220 protrudes towards the avoidance space 211 enclosed by the edge bearing portion 210 relative to an inner peripheral edge of the edge bearing portion 210. The extension direction of the edge bearing portion 210 is an extension direction of an arc enclosing the avoidance space 211. By providing the plurality of extending bearing portions 220, the plurality of extending bearing portions 220 can jointly support the partial region of the wafer extending from the edge of the wafer to the middle of the wafer, so that the wafer can be supported more when the wafer carrier 200 supports the wafer, which can further relieve the warpage of the wafer when the wafer carrier 200 bears the wafer.

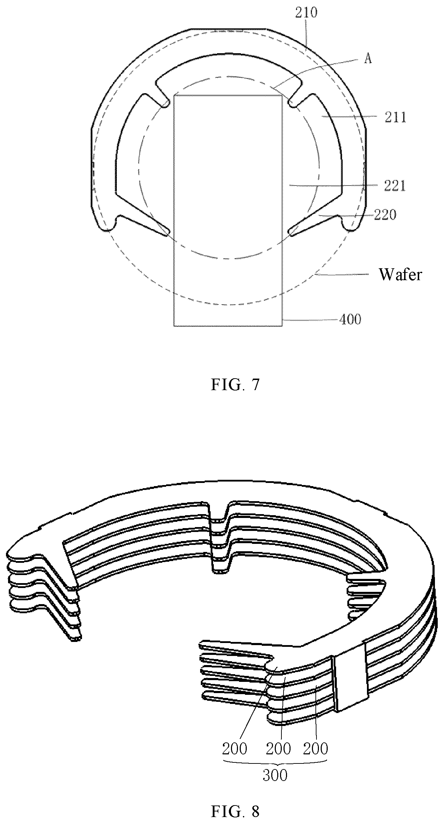

Optionally, one end of each of the plurality of extending bearing portions 220 away from the edge bearing portion 210 may be located on a same circumference. For example, as shown in FIG. 7, the ends of the plurality of extending bearing portions 220 away from the edge bearing portion 210 are substantially located on a circumference A. By locating the ends of the plurality of the extending bearing portions 220 away from the edge bearing portion 210 on the same circumference, the plurality of the extending bearing portions 220 have same supporting lengths in radial directions of the wafer when the wafer carrier 200 supports the wafer, so that deformation of the wafer caused by non-uniform support can be avoided.

Specifically, a diameter of the circumference where the ends of the plurality of extending bearing portions 220 away from the edge bearing portion 210 are located may be between one-half of a diameter of a corresponding carried wafer and two-thirds of the diameter of the corresponding carried wafer. For example, the diameter of the circumference where the ends of the plurality of extending bearing portions 220 away from the edge bearing portion 210 are located may be one-half of the diameter of the carried wafer. **In** a case where end surfaces of the edge bearing portion 210 facing the avoidance space 211 are located on a same circle, a circle enclosed by the end surfaces of the edge bearing portion 210 facing the avoidance space 211 and a circle enclosed by the ends of the plurality of extending bearing portions 220 away from the edge bearing portion 210 may be concentrically arranged, and a diameter of the circle enclosed by the end surfaces of the edge bearing portion 210 facing the avoidance space 211 may be two-thirds of the diameter of the carried wafer. Certainly, the diameter of the circumference where the ends of the plurality of extending bearing portions 220 away from the edge bearing portion 210 are located may be two-thirds of the diameter of the carried wafer, and the diameter of the circle enclosed by the end surfaces of the edge bearing portion 210 facing the avoidance space 211 may be five-sixths of the diameter of the carried wafer.

In an alternative embodiment, the extending bearing portion 220 may be disposed at an inner edge of the edge bearing portion 210 which is configured to enclose the avoidance space 211. A length direction of the extending bearing portion 220 may be consistent with an extension direction of the inner edge, a width direction of the extending bearing portion 220 may be a direction in which the extending bearing portion 220 extends towards a center of the wafer carrier 200 (e.g., a center of the circle enclosed by the end surfaces of the edge bearing portion 210 facing the avoidance space 211), and an inner edge of the extending bearing portion 220 close to the center of the wafer carrier 200 may enclose a wafer-transfer-device entrance space 221. The entrance space 221 is the middle region of the avoidance space 211.

In order to increase a contact area of the extending bearing portion 220 with the wafer as much as possible while ensuring the sufficient entrance space 221, a size of the extending bearing portion 220 in the direction in which the extending bearing portion 220 extends towards the center of the wafer carrier 200 needs to be not too large to ensure the sufficient entrance space 221, and meanwhile, a size of the extending bearing portion 220 in the extension direction of the inner edge of the extending bearing portion 220 is increased as much as possible to increase the contact area of the extending bearing portion 220 with the wafer. Based on this, according to the embodiment of the present disclosure, by configuring the length direction of the extending bearing portion 220 to be consistent with the extension direction of the inner edge and configuring the width direction of the extending bearing portion 220 to be the direction in which the extending bearing portion 220 extends towards the center of the wafer carrier 200, the contact area of the extending bearing portion 220 with the wafer can be increased as much as possible while ensuring the sufficient entrance space 221, so that the wafer can be well prevented from warping greatly, and thus the wafer boat can be used to support relatively soft wafers such as a pure resin wafer. Further preferably, in order to increase the contact area of the extending bearing portion 220 with the wafer to the greatest extent, only one extending bearing portion 220 is provided and is a sheet structure, so that the extending bearing portion 220 is a continuous structure along the inner edge thereof. Compared with the extending bearing portion 220 being a discontinuous structure, the extending bearing portion 220 being the continuous structure has a larger contact area with the wafer, so that the wafer can be better prevented from warping greatly, and thus the wafer boat can be used to support the relatively soft wafers such as the pure resin wafer.

In order to improve overall strength of the wafer carrier 200, optionally, the extending bearing portion 220 and the edge bearing portion 210 may be a one-piece structure. By configuring the extending bearing portion 220 and the edge bearing portion 210 as the one-piece structure, the overall strength of the wafer carrier 200 can be improved.

In an alternative embodiment, the support 100 may include a top plate 110, a bottom plate 120, and a plurality of auxiliary support columns 130, two ends of each of the plurality of auxiliary support columns 130 may be connected to the top plate 110 and the bottom plate 120 respectively, the plurality of auxiliary support columns 130 may be provided with slots 131 at corresponding heights, and sidewalls of the slots 131 of the plurality of auxiliary support columns 130 at a same height may be configured to jointly support the edge bearing portion 210.

In the specific structure of the support 100 provided in the embodiment of the present disclosure, by providing the auxiliary support columns 130 with the slots 131, the sidewalls of the slots 131 of the plurality of auxiliary support columns 130 at the same height can jointly support the edge bearing portion 210, thereby realizing the support for the wafer carrier 200.

In order to make the connection between the wafer carrier 200 and the support 100 stable, optionally, the sidewalls of the slots 131 may be provided with positioning recesses 131a, and the edge bearing portion 210 may be provided with a positioning protrusion 212. When the positioning protrusion 212 is located in the positioning recesses 13 1a, the sidewalls of the slots 131 of the plurality of auxiliary support columns 130 at the same height jointly support the edge bearing portion 210.

By providing the sidewalls of the slots 131 with the positioning recesses 131a and providing the edge bearing portion 210 with the positioning protrusion 212, when the positioning protrusion 212 is located in the positioning recesses 131a, the sidewalls of the slots 131 of the plurality of auxiliary support columns 130 at the same height jointly support the edge bearing portion 210, and the positioning protrusion 212 is in positioning fit with the positioning recesses 131a, which makes the connection between the wafer carrier 200 and the support 100 stable.

The wafer boat generally needs to bear a plurality of wafers, for example, the wafer boat needs to bear 100 wafers. Therefore, the wafer boat needs to be provided with a plurality of wafer carriers 200. It takes a lot of time for mounting the plurality of wafer carriers 200 to the support 100 one by one, resulting in a reduction of wafer transfer efficiency of the wafer boat. **In** order to improve the wafer transfer efficiency of the wafer boat, in an alternative embodiment, a plurality of wafer carriers 200 may be provided, the plurality of wafer carriers 200 may be stacked and connected in sequence to form a wafer carrier group 300, a gap for accommodating the wafer may be formed between any two adjacent wafer carriers 200 in the wafer carrier group 300, and the wafer carrier group 300 may be detachably connected to the support 100.

By stacking and connecting the plurality of wafer carriers 200 in sequence to form the wafer carrier group 300 and forming the gap for accommodating the wafer between any two adjacent wafer carriers 200 in the wafer carrier group 300, the wafer carrier group 300 formed by the plurality of wafer carriers 200 can be mounted to the support 100 at one time during the installation of the wafer carriers 200 to the support 100, so that the time consumed by the installation of the wafer carriers 200 to the support 100 can be reduced, and the wafer transfer efficiency of the wafer boat can be improved.

**In** the related art adopting the three-column short-tooth boat as the wafer boat, each kind of wafer boat can be used in only one specific process environment, because a distance between adjacent wafers carried on the three-column short-tooth wafer boat in the related art is fixed and cannot be changed and the distance may be possibly suitable for only one specific process environment. Therefore, once a requirement of the process environment for the distance is changed, such kind of wafer boat cannot be used and needs to be replaced with another kind of wafer boat with a different distance, resulting in low usage performance of each kind of wafer boat. In order to improve the usage performance of the wafer boat, optionally, the plurality of wafer carriers 200 may form a plurality of wafer carrier groups 300, and a distance between the wafer carriers 200 in at least one of the plurality of wafer carrier groups 300 is different from distances between the wafer carriers 200 in the other wafer carrier groups 300. Since a thickness of a wafer carrier group 300 is different from that of a single wafer carrier 200, the auxiliary support columns 130 may be divided into a plurality of groups, the plurality of groups of auxiliary support columns 130 are different in a distance between the slots 131, and the plurality of groups of auxiliary support columns 130 may be detachably connected to the top plate 110 and the bottom plate 120, so as to facilitate replacement of the auxiliary support columns 130. The distances between the slots 131 at the different groups of auxiliary support columns 130 may fit the thicknesses of the corresponding wafer carrier groups 300.

By providing the plurality of wafer carrier groups 300 and making the distance between the wafer carriers 200 in at least one of the plurality of wafer carrier groups 300 different from the distances between the wafer carriers 200 in the other wafer carrier groups 300, the same boat can meet a requirement that the distance between the wafers is required to be different in different process environments, thereby improving the usage performance of the wafer boat.

Optionally, a plurality of wafer carriers 200 may be provided, and the plurality of wafer carriers 200 may form a plurality of combinations each including at least one wafer carrier 200. Each edge bearing portion 210 may include an outer edge and an inner edge, the inner edge may face the avoidance space 211, and the outer edge may be away from the avoidance space 211, and a width from the inner edge to the outer edge of the edge bearing portion 210 in at least one of the plurality of combinations is different from widths from the inner edges to the outer edges of the edge bearing portions 210 in the other combinations. The inner edge may face the avoidance space 211, the outer edge may be away from the avoidance space 211, a direction in which the outer edge points to the inner edge may be a direction in which the edge bearing portion 210 extends towards the inside of the avoidance space 211, and the width from the inner edge to the outer edge may refer to a distance dimension of the edge bearing portion 210 in the direction in which the edge bearing portion 210 extends towards the inside of the avoidance space 211, for example, the width from the inner edge to the outer edge may be 5mm, 10mm, or the like.

According to the embodiments of the present disclosure, by dividing the plurality of wafer carriers 200 into the plurality of combinations and making the width from the inner edge to the outer edge of the edge bearing portion 210 in at least one of the plurality of combinations different from the widths from the inner edges to the outer edges of the edge bearing portions 210 in the other combinations, the wafer boat can bear the wafers with different sizes by replacement of different combinations of wafer carriers 200, thereby further improving wafer bearing capability of the wafer boat.

**In** some embodiments, a plurality of wafer carriers 200 may be provided, and the plurality of wafer carriers 200 may form a plurality of combinations each including at least one wafer carrier 200. An extension depth of the extending bearing portion 220 towards the avoidance space 211 in at least one of the plurality of combinations is different from extension depths of the extending bearing portions 220 towards the avoidance spaces 211 in the other combinations.

According to the embodiments of the present disclosure, by dividing the plurality of wafer carriers 200 into the plurality of combinations and making the extension depth of the extending bearing portion 220 towards the avoidance space 211 in at least one of the plurality of combinations different from the extension depths of the extending bearing portions 220 towards the avoidance spaces 211 in the other combinations, the wafer boat can bear the wafers with different sizes by replacement of different combinations of wafer carriers 200, thereby further improving the wafer bearing capability of the wafer boat.

Optionally, a plurality of extending bearing portions 220 are provided, ends of the plurality of extending bearing portions 220 away from the edge bearing portion 210 may enclose the wafer-transfer-device entrance space 221, and the avoidance space 211 may include the wafer-transfer-device entrance space 221. The wafer-transfer-device entrance space 221 may be communicated with the opening of the avoidance space 211. With the ends of the plurality of extending bearing portions 220 away from the edge bearing portion 210 enclosing the wafer-transfer-device entrance space 221, the wafer transfer device 400 can be easily moved in and out of the wafer-transfer-device entrance space 221 to pick and place the wafer.

**In** some embodiments, the support 100 further includes a heat insulation plate 140, the heat insulation plate 140 is configured to be inserted in the auxiliary support columns 130 to divide the auxiliary support columns 130 into a first part and a second part, the first part is configured to support the wafer carrier 200, and the second part is used for the installation of the heat insulation plate. When the wafer boat enters a process chamber through a transfer port of the process chamber of the semiconductor process apparatus, the first part of the wafer boat enters the process chamber first, one end of the second part away from the first part is connected to a process door, the process door blocks the transfer port of the process chamber, and the heat insulation plate is configured to cut off heat conduction between the first part and the process door.

The present disclosure further provides a semiconductor process apparatus, including a wafer transfer device 400 and the wafer boat provided in the above embodiments, and the wafer transfer device 400 is configured to pick a wafer from the wafer boat and place the wafer on the wafer boat. The wafer transfer device 400 is configured to transfer the wafer to the wafer carrier 200 or transfer the wafer from the wafer carrier to other positions. By adopting the wafer boat provided in the above embodiments, the wafer boat is configured to include the support 100 and the wafer carrier 200, the wafer carrier 200 is configured as a structure including the edge bearing portion 210 and the extending bearing portion 220, the edge bearing portion 210 encloses the avoidance space 211 having the opening, the extending bearing portion 220 is connected to the edge bearing portion 210 and extends towards the avoidance space 211. With the above configurations, when the wafer boat supports the wafer, the edge bearing portion 210 can support the edge region of the wafer, and the extending bearing portion 220 can support the partial region of the wafer extending from the edge of the wafer to the middle of the wafer, so that the edge of the wafer and the partial region of the wafer extending from the edge of the wafer to the middle of the wafer can be supported, which can solve the problem in the related art that the wafer while being borne by the wafer boat has the serious warpage problem because just several points of the edge of the wafer are supported.

The above embodiments of the present disclosure focus on the differences between the embodiments, and different optimization features of the embodiments can be combined to form better embodiments as long as the different optimization features are not contradictory, which will not be described in detail here for conciseness of the description.

The embodiments of the present disclosure are described above with reference to the drawings, but the present disclosure is not limited to the above specific implementations which are only for illustration rather than for limitation. Enlightened by the present disclosure, those of ordinary skill in the art can make many variations without departing from the spirit of the present disclosure and the scope of the claims, and all those variations should be considered to fall within the scope of the present disclosure.

## Claims

1. A wafer boat, comprising a support and a wafer carrier connected to the support, wherein:
the wafer carrier comprises an edge bearing portion and an extending bearing portion, the edge bearing portion encloses an avoidance space having an opening, the extending bearing portion is connected to the edge bearing portion and extends towards the avoidance space, the edge bearing portion and the extending bearing portion are configured to support a wafer together, and the edge bearing portion is configured to support an edge region of the wafer.

2. The wafer boat of claim 1, wherein a plurality of extending bearing portions are provided, and the plurality of extending bearing portions are arranged at intervals along an extension direction of the edge bearing portion.

3. The wafer boat of claim 2, wherein one end of each of the plurality of extending bearing portions away from the edge bearing portion is located on a same circumference.

4. The wafer boat of claim 1, wherein the extending bearing portion is disposed at an inner edge of the edge bearing portion which is configured to enclose the avoidance space, a length direction of the extending bearing portion is consistent with an extension direction of the inner edge, a width direction of the extending bearing portion is a direction in which the extending bearing portion extends towards a center of the wafer carrier, and an inner edge of the extending bearing portion close to the center of the wafer carrier encloses a wafer-transfer-device entrance space.

5. The wafer boat of claim 4, wherein the extending bearing portion is a sheet structure.

6. The wafer boat of any one of claims 1 to 5, wherein the extending bearing portion and the edge bearing portion are a one-piece structure.

7. The wafer boat of any one of claims 1 to 5, wherein the support comprises a top plate, a bottom plate, and a plurality of auxiliary support columns, two ends of each of the plurality of auxiliary support columns are connected to the top plate and the bottom plate respectively, the plurality of auxiliary support columns are provided with slots at corresponding heights, and sidewalls of the slots of the plurality of auxiliary support columns at a same height are configured to jointly support the edge bearing portion.

8. The wafer boat of claim 7, wherein the sidewalls of the slots are provided with positioning recesses, the edge bearing portion is provided with a positioning protrusion, and when the positioning protrusion is located in the positioning recesses, the sidewalls of the slots of the plurality of auxiliary support columns at the same height jointly support the edge bearing portion.

9. The wafer boat of any one of claims 1 to 5, wherein a plurality of wafer carriers are provided, the plurality of wafer carriers are stacked and connected in sequence to form a wafer carrier group, a gap for accommodating the wafer is formed between any two adjacent wafer carriers in the wafer carrier group, and the wafer carrier group is detachably connected to the support.

10. The wafer boat of claim 9, wherein the plurality of wafer carriers form a plurality of wafer carrier groups, and a distance between the wafer carriers in at least one of the plurality of wafer carrier groups is different from distances between the wafer carriers in the other wafer carrier groups.

11. The wafer boat of claim 1, wherein a plurality of wafer carriers are provided, the plurality of wafer carriers form a plurality of combinations each comprising at least one wafer carrier, the edge bearing portion comprises an outer edge and an inner edge, the inner edge faces the avoidance space, the outer edge is away from the avoidance space, and a width from the inner edge to the outer edge of the edge bearing portion in at least one of the plurality of combinations is different from widths from inner edges to outer edges of edge bearing portions in the other combinations; and/or, an extension depth of the extending bearing portion towards the avoidance space in at least one of the plurality of combinations is different from extension depths of extending bearing portions towards avoidance spaces in the other combinations.

12. The wafer boat of claim 2, wherein ends of the plurality of extending bearing portions away from the edge bearing portion enclose a wafer-transfer-device entrance space, and the avoidance space comprises the wafer-transfer-device entrance space.

13. A semiconductor process apparatus, comprising a wafer transfer device and a wafer boat of any one of claims 1 to 12, the wafer transport device being configured to pick the wafer from the wafer boat and place the wafer on the wafer boat.
